# EUROPEAN PATENT APPLICATION

(11) **EP 3 135 395 A1**
(43) Date of publication of application: **01.03.2017**
(21) Application number: 15783193.4
(22) Date of filing: 22.04.2015
(51) Int. Cl.: B21D 37/01, B21D 22/20, B21D 24/00

(54) **MOLD FOR HOT-FORMING Zn-PLATED STEEL SHEET**

(30) Priority: 22.04.2014 JP 2014088271
(71) Applicant: Kabushiki Kaisha Kobe Seiko Sho (Kobe Steel, Ltd.), Kobe-shi, Hyogo 651-8585 (JP)
(72) Inventor: YAMAMOTO, Kenji, Kobe-shi, Hyogo 651-2271 (JP)
(74) Representative: Müller-Boré & Partner Patentanwälte PartG mbB
(86) International application number: PCT/JP2015/062310
(87) International publication number: WO 2015/163386

(57) **Abstract**

A mold for hot-forming a Zn-plated steel sheet, wherein at least the portion of the mold that makes contact with the Zn-plated steel sheet during hot forming is covered with an amorphous carbon film satisfying the following four conditions. (1) The film thickness is 0.5 µm or greater. (2) The arithmetic mean roughness (Ra) of the surface is 2.0 µm or less. (3) The root mean square gradient (RAq) of the surface is 0.50° or less. (4) The hydrogen content is 30 at% or less.

## Description

### Technical Field

The present invention relates to a forming tool for hot forming of Zn-plated steel sheets. The present invention particularly relates to a forming tool which is used in performing a hot pressing, after a Zn-plated steel sheet is heated at a high temperature in the austenite range. The hot pressing is referred to also as hot stamping, die quenching, press quenching, or hot pressing.

### Background Art

The hot pressing method has problems such as the following. The hot pressing method is a technique in which a blank that is a steel sheet is heated usually to a temperature range of austenite of 800 to 900°C and then rapidly cooled and simultaneously formed into a desired part shape by means of a water-cooled forming tool. The steps from the heating of the steel sheet to the pressing are conducted in the air from the standpoint of cost. Consequently, for the purpose of inhibiting scale formation due to steel sheet oxidation, a Zn-plated steel sheet which has a plated layer consisting mainly of Zn formed on the surfaces thereof is often used as that steel sheet. However, since the melting point of Zn is lower than the heating temperature of the steel sheet, the Zn softens during the high-temperature forming. Because of this, in the cases when the Zn-plated steel sheet is used as a blank, the softened Zn adheres to the forming tool for pressing as the number of pressing shots increases. In the case where this adhesion of Zn is serious, the shape of the forming tool is changed, arousing problems concerning product shape and the surface quality of the formed steel sheet. Hereinafter, the adhesion of Zn to a forming tool is sometimes referred to simply as "Zn adhesion".

In general, in forming tools for use in the hot pressing, a ceramic coating film of, for example, TiN is formed as a coating on the surfaces of the forming tools as a measure against wear by abrasion with steel sheets. However, the ceramic coating film is not considered to be sufficient for inhibiting the Zn adhesion to the forming tools.

With respect to forming with forming tools, examples of techniques for inhibiting the adhesion of a soft metal to forming tools include the following techniques of Patent Document 1 and Patent Document 2.

Patent Document 1 discloses a cold-pressing apparatus for magnesium alloy materials, in which cold pressing of a magnesium alloy material can be carried out at room temperature successively and continuously without causing a trouble to the tool surface of the press-forming tool and in the state of capable of mass production. Specifically, the document shows that a superhard film has been formed by a coating treatment on the tool surface of the press-forming tool. It also shows that the superhard film is constituted of one kind or two more kinds selected from among TiN, TiCN, CrN, TiAIN, Al₂O₃, and DLC (diamond like carbon).

Meanwhile, Patent Document 2 discloses, in a forming of magnesium alloy member, a method for forming a formed product easily and at low cost while avoiding fusion bonding to the forming tool even when neither a lubricant nor a sheet-shaped member is used. Specifically, the document discloses a method in which at least a part of the portion to be in contact with the magnesium alloy member in the forming tool is coated with a diamond film and the surface of the diamond film is polished to a maximum surface roughness of 0.1 µm or more and 1.0 µm or less, and in which pressing is conducted so that the diamond film of the forming tool after polishing comes into direct contact with the magnesium alloy member.

However, in the case of Zn, which becomes soft at a lower temperature than the magnesium, only the means of Patent Document 1 and Patent Document 2 cannot sufficiently inhibit adhesion to the forming tool. Patent Document 1 mentions coating films of nitrides such as TiN and TiAIN, together with DLC, and indicates that these nitride coating films are effective in adhesion inhibition. In the case of Zn, however, such nitride coating films have no effect of inhibiting the adhesion, as will be demonstrated in the Examples given later. Furthermore, although DLC has also been mentioned, further investigations on the surface profile, etc. of the DLC film are necessary for effectively inhibiting the adhesion of Zn, as will be described later. Namely, it is presumed that Zn differs in the mechanism of adhesion from Mg, which Patent Document 1 and Patent Document 2 address, and it is considered that separate investigations are necessary for inhibiting the adhesion of Zn.

### Prior Art Documents

### Patent Documents

Patent Document 1: JP-A-2003-154418
Patent Document 2: JP-A-2009-172640

### Summary of the Invention

### Problem that the Invention is to Solve

An object of the present invention, which has been achieved by focusing on the circumstances described above, is to realize a forming tool which is for use in a hot forming of a Zn-plated steel sheet and to which the Zn of the Zn-plated steel sheet is less apt to adhere. Hereinafter, the property whereby "the Zn of the Zn-plated steel sheet is less apt to adhere" is sometimes referred to as "Zn adhesion resistance ".

### Means for Solving the Problem

The forming tool for a hot forming of the present invention, which has overcome the problem, is a forming tool for use in a hot forming of a Zn-plated steel sheet, in which at least a portion to be in contact with the Zn-plated steel sheet during the hot forming in the forming tool is covered with an amorphous-carbon coating film that satisfies all of the following (1) to (4):
(1) a film thickness is 0.5 µm or larger;
(2) a surface has an arithmetic mean roughness Ra of 2.0 µm or less;
(3) the surface has a root-mean-square slope RΔq of 0.50° or less; and
(4) a hydrogen content is 30 atom% or less.

In a preferred embodiment of the present invention, the amorphous-carbon coating film has a skewness Rsk in the surface thereof of a negative value.

The amorphous-carbon coating film may contain at least one metallic element of W and Si, in a total of up to 20 atom% in a proportion to all elements.

In a preferred embodiment of the present invention, the amorphous-carbon coating film has a hydrogen content of 5 atom% or higher.

In a preferred embodiment of the present invention, bonds of carbon constituting the amorphous-carbon coating film have a proportion of sp2 bonds equal to or larger than a proportion of sp3 bonds.

### Effect of the Invention

According to the present invention, it is possible to provide a forming tool which is for use in a hot forming of a Zn-plated steel sheet and to which the Zn of the Zn-plated steel sheet is less apt to adhere in the hot forming.

### Modes for Carrying Out the Invention

The present inventor diligently made investigations in order to solve the problem. As a result, the inventor has found that in the cases when, in a forming tool to be used for a hot-forming of a Zn-plated steel sheet, at least a portion thereof to be in contact with the Zn-plated steel sheet during the hot forming is covered with a coating film in which control elements that are divided roughly into the following two are within specified ranges, then the Zn adhesion to the forming tool surface is remarkably inhibited when the forming tool comes into contact with the Zn of the Zn-plated steel sheet. The present invention has been thus completed.

The first control element is the surface profile of the coating film. Since the Zn-plated steel sheet is heated to a high temperature and formed in hot pressing as stated above, the Zn present in the surface of the Zn-plated steel sheet which is in contact with the forming tool has softened. In the cases when the surface of the forming tool has a shape with projections, Zn transfers and adheres to the forming tool surface due to the Zn-digging effect by the projections. Consequently, in the present invention, it has been first found that for inhibiting the digging and the accompanying transfer and adhesion of Zn, it is necessary that the arithmetic mean roughness Ra of the surface should satisfy 2.0 µm or less. The Ra is preferably 1.0 µm or less and more preferably 0.5 µm or less. The smaller the Ra, the more preferred. For example, it can be reduced to about 0.01 µm, which indicates a supermirror surface.

The regulation of Ra alone is not sufficient for inhibiting Zn adhesion, and it is necessary that the root-mean-square slope RΔq of the surface should also be regulated. The RΔq indicates the slope of roughness, and there is a tendency that the smaller the RΔq, the gentler the slope. It has been found that by regulating the RΔq to 0.50° or less along with the Ra, Zn adhesion can be inhibited without fail in the present invention. The RΔq is preferably 0.10° or less and more preferably 0.05° or less. The smaller the RΔq, the more preferred. However, a lower limit of RΔq is about 0.001° when producibility, etc. are taken into account.

Zn is a metal which is highly prone to adhere, as stated above. Physical control, such as controls of roughness and surface state, is not sufficient for inhibiting the adhesion of Zn. Consequently, from the standpoint of reducing reactivity with Zn when in contact with Zn, it is necessary that the material of the surface to be in contact with Zn should be investigated as the second element to be controlled. The present inventor, from this standpoint, has discovered that amorphous-carbon coating films are suitable as substances showing reduced reactivity with Zn, and that among those, an amorphous-carbon coating film which has a hydrogen content, i.e., a proportion of hydrogen to the sum of carbon and hydrogen, of 30 atom% or less is suitable. The amorphous-carbon coating film is hereinafter sometimes referred to as DLC film.

In the case where the hydrogen content of the DLC film exceeds 30 atom%, this DLC film has reduced heat resistance to show a considerable alteration or deterioration due to the heat during the forming. As a result, Zn adhesion is prone to occur. The hydrogen content is preferably 25 atom% or less and more preferably 10 atom% or less. Meanwhile, in the case where hydrogen is not contained at all, there is a tendency that Zn adhesion is rather enhanced. It is hence preferable that the hydrogen content is 5 atom% or higher.

From the standpoint of further inhibiting Zn adhesion, it is preferable that the value of skewness Rsk, which is a parameter indicating the asymmetry between the recesses and protrusions of the surface to be in contact with Zn, is negative. In the case where the Rsk is negative, the number of sharp projections, which serve as starting points for Zn adhesion, is small. The skewness Rsk is more preferably -1 or less. A lower limit of the skewness Rsk is about -10.

The arithmetic mean roughness Ra is the arithmetic mean roughness Ra regarding contour curve, among the height-direction parameters defined in JIS B 0601 (2013). The root-mean-square slope RΔq is the root-mean-square slope regarding contour curve which is a combined parameter as defined in the same JIS, and the skewness Rsk is the skewness Rsk regarding contour curve, among the height-direction parameters defined in the same JIS. The definition of each parameter and a method for determination thereof are based on the description of JIS B 0601 (2013).

In order to enhance the heat resistance of the DLC film during hot working, the DLC film according to the present invention may contain at least one metallic element of W and Si. For exerting the effect, it is preferable that the proportion of the metallic element(s) to the sum of carbon, hydrogen if hydrogen is contained, and the metallic element(s) is 0.5 atom% or higher. The expression "proportion of the metallic elements(s)" means the amount added alone when the metallic element is contained alone, and means the total amount when the two elements are contained. The same applies hereinafter. The proportion of the metallic element(s) is more preferably 1.0 atom% or higher, even more preferably 2.0 atom% or higher and especially preferably 5.0 atom% or higher. However, in the case where the proportion of the metallic element(s) is too high, this is causative of a decrease in the hardness of the coating film and a change in surface roughness and the resultant increase in adhesion. Consequently, the proportion of the metallic element(s) is preferably 20 atom% or less and more preferably 10 atom% or less.

In the case where the metallic element(s) are contained, the expression "hydrogen content of the DLC film" means the proportion of hydrogen (atom%) to the sum of carbon, hydrogen and the metallic element(s).

As is well known, DLC is an amorphous inorganic substance which has intermediate properties between diamond and graphite. Diamond is constituted only of sp3 hybridized orbital and graphite is constituted only of sp2 hybridized orbital, whereas DLC is considered to include both carbon atoms which show properties of diamond and carbon atoms which show properties of graphite. The properties of DLC are governed by the ratio between sp2 bonds which are graphitic bonds and sp3 bonds which are diamondlike bonds, in the coating film. The inventor investigated a relationship between Zn adhesion resistance and the ratio between the sp2 bonds and the sp3 bonds and, as a result, it has been found that for enhancing Zn adhesion resistance, it is preferable that the bonds of the carbon constituting the DLC film is in such a state that the proportion of sp2 bonds is equal to or larger than the proportion of sp3 bonds. Namely, it is preferable that the bonds of the carbon constituting the DLC film has a proportion represented by 100×(sp2 bonds)/[(sp2 bonds)+(sp3 bonds)] of 50% or larger. This proportion is more preferably 70% or larger. There are cases where the proportion is substantially 100%. The larger the proportion of sp2 bonds, the better the Zn adhesion resistance. It is, however, noted that too large the proportion tends to result in poor wear resistance, and it is hence preferable that the proportion of sp2 bonds is 80% or less. The proportion of each kind of bonds in the DLC film can be determined by a method such as electron energy-loss spectroscopy (EELS).

The film thickness of the DLC film according to the present invention is 0.5 µm or larger. This is because in the case where the film thickness is less than 0.5 µm, there are cases where the covering is insufficient and the substrate is exposed. The film thickness is preferably 1.0 µm or larger. Meanwhile, in the case where the film thickness of the DLC film is too large, peeling is prone to occur. It is therefore preferable that the film thickness of the DLC film is 10 µm or less. It is more preferably 5 µm or less.

So long as the forming tool is one in which at least a portion to be in contact with the Zn-plated steel sheet during hot forming is covered with the DLC coating film specified in the present invention, the covering of portions thereof not to be in contact with the Zn-plated steel sheet is not particularly limited.

The forming tool of the present invention is not limited so long as the outermost surface thereof is constituted of the DLC film specified in the present invention. A film constituted of, for example, CrN, TiN or the like or any of a film of metallic Cr, a film of metallic W, a gradient layer in which the composition changes gradually from W to C, and the like, which are shown in the Examples given later, may have been formed as an interlayer between the DLC film constituting the outermost surface and the substrate.

Examples of the forming tool of the present invention for the hot forming of a Zn-plated steel sheet include dies, punches and pads. Examples of the Zn-plated steel sheet include hot-dip galvanized steel sheets, hot-dip galvannealed steel sheets and electrogalvanized steel sheets.

Methods for forming the DLC film specified in the present invention are not particularly limited. For example, use can be made of vapor deposition methods such as chemical vapor deposition (CVD), e.g., plasma chemical vapor deposition, and physical vapor deposition (PVD), e.g., arc ion plating and sputtering. These may be used alone or in combination. For example, in the sputtering, a DLC film may be deposited by using a graphite target while introducing a hydrocarbon gas such as methane or acetylene during the deposition. In the case of the CVD method, a recommended method is to use a hydrocarbon gas, such as methane, acetylene or toluene, and apply DC bias or RF bias thereto to directly ionize it, thereby depositing a DLC film.

Preferred film deposition methods are sputtering methods. More preferred of these is un-balanced magnetron sputtering (UBMS). The UBMS conditions may be, for example, a substrate temperature of room temperature to 400°C, a total gas pressure of 0.5 to 5 Pa, a negative bias voltage in DC mode of 100 to 1,600 V, a positive/negative bias voltage in AC mode of 100 to 1,600 V, and a voltage supply to the carbon target of 0.1 to 3.0 kW.

In the case of producing, as the DLC film, a film that contains at least one metallic element of the W and Si, the pure metal(s) constituted of the metallic element(s) or a carbide or the like of the metallic element(s) can be used as a target together with the carbon target. In the case of the Si, it is also possible to use an Si-containing gas, such as SiH₄, as a film deposition gas.

Examples of methods for attaining a hydrogen content in the DLC film of 30 atom% or less, in the case of sputtering, include regulating the flow rate of a hydrocarbon gas, e.g., methane that is caused to flow during the process. In the case of CVD, examples include to increase the bias voltage and to elevate the substrate temperature.

Examples of methods for obtaining a DLC film in which the proportion of sp2 bonds in the bonds of the carbon constituting the DLC film is equal to or higher than the proportion of sp3 bonds include to regulate the voltage being applied to the substrate during the film deposition.

Examples of methods for regulating so that the Ra, RΔq and Rsk specified in the present invention are satisfied include polishing the surface of a DLC film formed by the method described above, for example, with a projection type polishing apparatus while changing the conditions including projection period and projection pressure. There is a tendency that as the projection period is made longer and the projection pressure is made higher, the factors Ra, RΔq and Rsk each become smaller. The polishing may be performed while ascertaining the value of each factor.

In the case where the surface has high roughness, it is desirable that large irregularities such as grinding flaws are removed in advance by a method such as buffing, and then the projection polishing is performed. Examples thereof include using diamond particles (abrasive grains) having an average particle diameter of 4 to 8 µm which are for use in mirror polishing as an abrasive material in order to carry out the polishing with only a slight polishing amount. Examples of devices for projecting such an abrasive material include AERO LAP (registered trademark; Yamashita Works Co., Ltd.).

Another method for regulation for satisfying the Ra, RΔq and Rsk is to regulate the surface roughness of the substrate before a DLC film is formed. The methods described above for regulating the surface roughness of the DLC film can be applied to methods for regulating the surface roughness of the substrate.

The roughness of the surface of the substrate before being covered with a DLC film is not necessarily regulated so as to fall in the Ra, RΔq and Rsk ranges for the DLC film. Examples include a method in which the substrate surface is processed, for example, by shot blasting or the like to regulate the Ra of the substrate surface to, for example, fall in the range of Ra 1.5 µm ± 20% and a DLC film is thereafter formed on the substrate surface in the manner described above. After the processing by the shot blasting, the substrate surface may be further polished, for example, by projection polishing in order to remove sharp angles formed by the shot blasting, so long as the shape of the substrate surface does not change considerably. After the surface roughness of the substrate is regulated and a DLC film is then formed, for example, projection polishing may be given to the surface of the DLC film for the purpose of further regulating the surface roughness of the DLC film, removing particles adherent to the surface or the like. In the case of forming an intermediate, the roughness of the surface of the interlayer may be regulated so as to be similar to the roughness of the substrate.

### Examples

The present invention is described more specifically below by referring to Examples, but the present invention is not limited by these Examples and can be of course implemented by appropriately adding changes as long as the gist described above and below can be observed, and these changes all are included in the technical scope of the present invention.

### [Example 1]

In Example 1, the influences of the composition and hydrogen content of a coating film on Zn adhesion resistance were examined. Hereinafter, a coating film formed on a substrate surface is often referred to as a coating.

A mirror-surface substrate constituted of SKD11 and having an HRC of 60 and a substrate Ra of 0.005 µm was prepared as a substrate for evaluating the surface profile of a coating. Meanwhile, a mirror-surface bending tool constituted of SKD61 and having a substrate Ra of 0.01 to 3 µm was prepared for evaluating Zn adhesion resistance. As a coating, each of coating films of nitrides, i.e., TiN, CrN and TiAIN, as conventional coating films, DLC films having the hydrogen contents shown in Table 1, and the DLC films containing Si or W as shown in Table 1 was formed on a surface of the substrate.

These coatings were formed by the un-balanced magnetron sputtering method. The film deposition conditions for the un-balanced magnetron sputtering method included a substrate temperature of 200°C, a total gas pressure of 0.6 Pa, an electric power input of 3 kW, and a target size of 6 inches in diameter. As a film deposition gas was used a mixed gas of methane gas and argon. Each film was formed for about 1 to 3 µm on the surface of the substrate. Regulation of the hydrogen contents of the DLC films was carried out by changing the amount of the methane gas or the bias voltage applied to the substrate. In the case of forming each DLC film, in order to improve adhesion to the iron-based substrate, an interlayer constituted of metallic Cr was deposited on the substrate, an interlayer constituted of metallic W was thereafter deposited, a gradient layer was subsequently formed in which the composition changed gradually from W to C, and the DLC film was then formed on the gradient layer. The DLC film containing Si or W was formed by using either the pure metal of that metallic element or a carbide or the like of the metallic element as a target together with the carbon target or by using SiH₄ as a film deposition gas in the case of Si.

In Example 1, an apparatus AERO LAP (registered trademark), manufactured by Yamashita Works Co., Ltd., was used as a projection type polishing apparatus after the coating to polish the coating surface. Thus, Ra, RΔq and Rsk of all the coatings were made to be equal as will be shown later.

The samples thus obtained were used to evaluate the surface properties in the following manner, and a Zn adhesion evaluation test simulating hot stamping was conducted to evaluate Zn adhesion resistance.

### (Measurement of Ra, RΔq and Rsk)

The Ra of each sample was measured by using a stylus type surface roughness meter (DekTak 6M). In the present invention, a scanning length was set to be 1 mm and the number of horizontal-direction measuring points was set to be 3,900 to measure a surface curve, from which a roughness curve was obtained by removing undulations therefrom. Ra, RΔq and Rsk were calculated from the roughness curve in accordance with JIS B 0601 (2013). These were measured at arbitrary five points on the surface, and average values thereof were employed. In Example 1, Ra was 0.1 µm, RΔq was 0.02° and Rsk was -1.0, in all the samples.

### (Evaluation of Zn adhesion resistance)

A hot-dip galvanized steel sheet was prepared as a sheet material which is a blank. The bending tools having the various coatings formed on the surfaces thereof were used to conduct bending of the galvanized steel sheet which had been heated, under the following forming conditions. Zn adhesion state in the surface of the forming tool after the bending was examined.

### (Forming conditions)

Blank: hot-dip galvanized steel sheet having tensile strength of 590 MPa and sheet thickness of 1.4 mm
Materials of the forming tool: SKD61 material + any of the various coatings shown in Table 1

### Pressing load: 1 t

### Heating temperature: 760°C

The Zn adhesion resistance was evaluated in the following manner. First, the surface roughness change (Ra) was measured before and after the Zn adhesion evaluation test, and the proportion of the change of the absolute value of Ra, i.e., [100× {(Ra before the adhesion test)-(Ra after the adhesion test)}/(Ra before the adhesion test)], was determined, and the evaluation was performed in four grades, i.e., 0 to 3, as follows. The case where the grade was 2 or less was regarded as acceptable. In particular, the case where the grade was 1 or less, i.e., 1 or 0, was evaluated as having better Zn adhesion resistance. The results thereof are shown in the column "Evaluation of Zn adhesion resistance" in Table 1.

### (Evaluation criteria for Zn adhesion resistance)

0··· the case of 5% or less
1··· the case of higher than 5% and 10% or lower
2··· the case of higher than 10% and 20% or lower
3··· the case of higher than 20%

**[Table 1]**

| No. | Coating | Film deposition method | Hydrogen content (atom%) | Evaluation of Zn adhesion resistance |
|---|---|---|---|---|
| 1 | TiN | UBMS | - | 3 |
| 2 | CrN | UBMS | - | 3 |
| 3 | (Ti0.5Al0.5)N *1 | UBMS | - | 3 |
| 4 | DLC | UBMS | 0 | 2 |
| 5 | DLC | UBMS | 5 | 1 |
| 6 | DLC | UBMS | 10 | 0 |
| 7 | DLC | UBMS | 25 | 0 |
| 8 | DLC | UBMS | 30 | 1 |
| 9 | DLC | UBMS | 50 | 3 |
| 10 | DLC-10%Si *2 | UBMS | 10 | 1 |
| 11 | DLC-10%W *2 | UBMS | 10 | 1 |
| 12 | DLC-25%Si *2 | UBMS | 10 | 3 |
| 13 | DLC-25%W *2 | UBMS | 10 | 3 |

| | | | | |
|---|---|---|---|---|
| In each sample, Ra was 0.1 µm, RΔq was 0.02° and Rsk was -1.0. * 1··· The numerals indicate atomic ratios. *2··· The numeral indicates the proportion (atom%) of Si/W in all the elements. | | | | |

The following can be seen from Table 1. First, Nos. 1 to 9 are discussed. It can be seen that in the case where the coatings are TiN, CrN or TiAIN, which are conventional nitride coating films, Zn adhesion resistance was poor as in Nos. 1 to 3. Although these nitride coating films are employed in Patent Document 1 in order to inhibit the adhesion regarding magnesium alloy materials, it can be seen that these nitride coating films are unable to attain ensuring excellent Zn adhesion resistance, regarding Zn which is prone to soften at lower temperatures then the magnesium.

In contrast, the DLC films satisfying a hydrogen content of 30 atom% or less showed excellent Zn adhesion resistance as in Nos. 4 to 8. In particular, by regulating the hydrogen content to 5 atom% or higher, more excellent Zn adhesion resistance was exhibited, as in Nos. 5 to 8. It can be seen from the results of Nos. 6 and 7 that in the cases when the hydrogen content is more preferably 10 atom% or more and 25 atom% or less, sufficiently excellent Zn adhesion resistance is exhibited. Meanwhile, even in the case of a DLC film, in the case where the hydrogen content therein exceeded 30 atom%, the Zn adhesion resistance was rather poor, as in No. 9.

Nos. 10 to 13 are examples of the DLC film containing at least one element of W and Si. Among these, the DLC films which satisfied a hydrogen content of 30 atom% or less and contained at least one element of W and Si in the specified amount showed excellent Zn adhesion resistance, as in Nos. 10 and 11. In contrast, in the cases when the content of the at least one element of W and Si exceeded 20 atom%, the Zn adhesion resistance was poor, as in Nos. 12 and 13.

### [Example 2]

In Example 2, the influence of the surface profile of a DLC film on Zn adhesion resistance was examined.

Samples were produced in the same manner as in Example 1, except that a substrate was coated with a DLC film having a hydrogen content of 10 atom% and the Ra, RΔq and Rsk were changed as shown in Table 2. In Example 1 and Example 3, which will be given layer, a substrate having a mirror surface was used. In this Example 2, however, the roughness of the substrate was varied by the method described above, and a DLC film was formed thereon. Thus, samples which varied in the Ra, RΔq and Rsk were prepared.

A Zn adhesion evaluation test was conducted in the same manner as in Example 1 to evaluate Zn adhesion resistance. The results thereof are shown in Table 2.

**[Table 2]**

| No. | Ra (µm) | RΔq (°) | Rsk (-) | Evaluation of Zn adhesion resistance |
|---|---|---|---|---|
| 1 | 0.01 | 0.01 | -2.0 | 0 |
| 2 | 0.1 | 0.03 | -2.0 | 0 |
| 3 | 0.5 | 0.05 | -1.0 | 0 |
| 4 | 1.0 | 0.10 | -0.5 | 1 |
| 5 | 2.0 | 0.30 | -0.2 | 1 |
| 6 | 3.0 | 0.40 | -0.2 | 3 |
| 7 | 2.0 | 0.60 | -0.1 | 3 |
| 8 | 2.0 | 0.70 | -0.1 | 3 |
| 9 | 2.0 | 0.30 | 0.5 | 2 |

The following can be seen from Table 2. No. 6 had too large a value of arithmetic mean roughness Ra and Nos. 7 and 8 each had too large a value of root-mean-square slope RΔq, therefore each of them gave results in which the Zn adhesion resistance was poor. In contrast, adhesion regarding Zn was sufficiently inhibited in Nos. 1 to 5, since the Ra and RΔq therein satisfied the specified ranges. A comparison between No. 5 and No. 9 shows that for further enhancing the Zn adhesion resistance, it is preferred to regulate the Rsk to a negative value.

### [Example 3]

In Example 3, the influence of the proportion of sp2 bonds in a DLC film on Zn adhesion resistance was examined.

Samples were produced in the same manner as in Example 1, except that one of the coating films was formed by the arc ion plating (AIP) method and that the voltage which was applied to the substrate during film deposition by the AIP method or UBMS method was changed to thereby form DLC films differing in the proportion of sp2 bonds as shown in Table 3. The hydrogen content was regulated in the same manner as in Example 1. The film deposition conditions for the arc ion plating method included a substrate temperature of 400°C, a total gas pressure of 4 Pa and a bias voltage of -50 V. A Zn adhesion evaluation test was conducted in the same manner as in Example 1 to evaluate Zn adhesion resistance.

The proportion of sp2 bonds was ascertained by EELS analysis. The measurement conditions for the EELS analysis are as follows.
EELS analysis apparatus: Tridiem, manufactured by Gatan Inc.
Dispersion: 0.3 eV/ch

The results of these are shown in Table 3.

**[Table 3]**

| No. | Coating | Film deposition method | Hydrogen content (atom%) | Proportion of sp2 (%) | Evaluation of Zn adhesion resistance |
|---|---|---|---|---|---|
| 1 | DLC | AIP | 10 | 0 | 2 |
| 2 | DLC | UBMS | 10 | 20 | 1 |
| 3 | DLC | UBMS | 10 | 50 | 0 |
| 4 | DLC | UBMS | 30 | 80 | 0 |
| 5 | DLC | UBMS | 30 | 100 | 1 |
| 6 | DLC-10%Si *2 | UBMS | 20 | 90 | 1 |
| 7 | DLC-10%W *2 | UBMS | 20 | 90 | 1 |
| 8 | DLC-25%Si *2 | UBMS | 20 | 90 | 3 |
| 9 | DLC-25%W *2 | UBMS | 20 | 90 | 3 |

| | | | | | |
|---|---|---|---|---|---|
| In each sample, Ra was 0.1 µm, RΔq was 0.02° and Rsk was -1.0. *2: The numeral indicates the proportion (atom%) of Si/W in all the elements. | | | | | |

The following can be seen from Table 3. A comparison between No. 1 and No. 2 and a comparison between Nos. 1 and 2 and Nos. 3 and 4 show that the higher the proportion of sp2 bonds, the better the Zn adhesion resistance. Nos. 8 and 9 gave results in which the Zn adhesion resistance was poor, because the alloying elements were contained in too large an amount although the coating films each had a hydrogen content within the specified range and had a proportion of sp2 bonds within the recommended range.

While the present invention has been described in detail and with reference to specific embodiments thereof, it will be apparent to one skilled in the art that various changes and modifications can be made therein without departing from the spirit and scope of the present invention.

The present application is based on Japanese Patent Application (Patent Application No. 2014-088271) filed on April 22, 2014, and the contents thereof are incorporated herein by reference.

### Industrial Applicability

The forming tool of the present invention is useful as forming tools for use in the hot-press forming of Zn-plated steel sheets, is less apt to cause Zn adhesion, and shows excellent formability.

## Claims

1. A forming tool for a hot forming of a Zn-plated steel sheet, which is a forming tool for use in a hot forming of a Zn-plated steel sheet, wherein at least a portion to be in contact with the Zn-plated steel sheet during the hot forming in the forming tool is covered with an amorphous-carbon coating film that satisfies all of the following (1) to (4):
(1) a film thickness is 0.5 µm or larger;
(2) a surface has an arithmetic mean roughness Ra of 2.0 µm or less;
(3) the surface has a root-mean-square slope RΔq of 0.50° or less; and
(4) a hydrogen content is 30 atom% or less.

2. The forming tool according to Claim 1, wherein the amorphous-carbon coating film has a skewness Rsk in the surface thereof of a negative value.

3. The forming tool according to Claim 1 or 2, wherein the amorphous-carbon coating film comprises at least one metallic element of W and Si, in a total of up to 20 atom% in a proportion to all elements.

4. The forming tool according to any one of Claims 1 to 3, wherein the amorphous-carbon coating film has a hydrogen content of 5 atom% or higher.

5. The forming tool according to any one of Claims 1 to 4, wherein bonds of carbon constituting the amorphous-carbon coating film have a proportion of sp2 bonds equal to or larger than a proportion of sp3 bonds.
